# EUROPÄISCHE PATENTANMELDUNG

(11) **EP 1 601 014 A1**
(43) Veröffentlichungstag der Anmeldung: **30.11.2005**
(21) Anmeldenummer: 04012449.7
(22) Anmeldetag: 26.05.2004
(51) Int. Cl.: H01L 23/40, H05K 7/20

(54) **Bauelementhalter für ein elektronisches Bauelement**

(71) Anmelder: Delphi Technologies, Inc., Troy, MI 48098 (US)
(72) Erfinder: Slawik, Ralf, 90537 Feucht (DE); Ambach, Bernd, 91126 Rednitzhembach (DE)
(74) Vertreter: Manitz, Finsterwald & Partner GbR

(57) **Zusammenfassung**

Die Erfindung betrifft einen Bauelementhalter für ein auf einer Platine zu montierendes und an einen Kühlkörper anzudrückendes elektronisches Bauelement mit einem Rastfederarm, durch den das Bauelement an den Kühlkörper andrückbar ist. Darüber hinaus betrifft die Erfindung auch ein Verfahren zum Montieren eines elektronischen Bauelements auf einer Platine sowie eine Platine, die mit einem einen Kühlkörper aufweisenden Chassis verbunden ist und ein elektrisch mit der Platine verbundenes elektronisches Bauelement aufweist.

## Beschreibung

Die Erfindung betrifft einen Bauelementhalter für ein auf einer Platine zu montierendes und an einen Kühlkörper anzudrückendes elektronisches Bauelement sowie ein Verfahren zum Montieren eines elektronischen Bauelements auf einer Platine. Darüber hinaus betrifft die Erfindung auch eine Platine, die mit einem einen Kühlkörper aufweisenden Chassis verbunden ist und ein elektrisch mit der Platine verbundenes elektronisches Bauelement aufweist.

Ein bekannter Bauelementhalter der eingangs genannten Art umfasst eine schlitzartige Aufnahme für ein Kühlblech und zwei Federarme, die auf gegenüber liegenden Seiten eines aufgenommenen Kühlblechs angeordnet sind. Zwischen das Kühlblech und jeden Federarm ist jeweils ein elektronisches Bauelement einsetzbar, das durch den entsprechenden Federarm an das Kühlblech angedrückt wird. Zur Bestückung einer Platine wird zunächst der Bauelementhalter auf der Platine montiert. Anschließend wird der Kühlkörper in den Bauelementhalter eingesetzt und danach auf jeder Seite des Kühlkörpers jeweils ein Bauelement derart zwischen Kühlkörper und Federarm geschoben, dass die Anschlusselemente jedes Bauelements mit entsprechenden Leiterbahnen der Platine verlötbar sind. Abschließend kann die Platine mit einem Chassis verbunden werden.

Bei einem anderen herkömmlichen Montageverfahren werden zunächst ein Kühlkörper und anschließend ein elektronisches Bauelement auf einer Platine montiert. Durch ein Halteblech wird das Bauelement an den Kühlkörper angedrückt und an diesem gesichert. Nach der Verlötung des Bauelements und des Kühlwinkels auf der Platine wird die so vorbereitete Platine mit einem Chassis verbunden und das Halteblech mit dem Chassis verschraubt. Als problematisch erweist sich bei diesem Verfahren, dass die für die Verschraubung des Halteblechs an dem Chassis benötigten Schrauben eine spezielle Größe erfordern, die bei den herzustellenden Geräten sonst nicht verbaut werden. Dieser spezielle Schraubentyp muss also eigens für die genannte Verbindung beschafft, gelagert und am Montageband bereitgestellt werden.

Der Erfindung liegt die Aufgabe zugrunde, einen vereinfachten Bauelementhalter zu schaffen, der eine von einem Kühlkörper unabhängige Halterung eines elektronischen Bauelements auf einer Platine ermöglicht. Eine weitere Aufgabe der Erfindung besteht darin, ein vereinfachtes Verfahren zum Montieren eines elektronischen Bauelements auf einer Platine und eine entsprechend bestückte Platine zu schaffen.

Zur Lösung der Aufgaben sind ein Bauelementhalter, ein Verfahren und eine Platine gemäß den unabhängigen Ansprüchen vorgesehen.

Ein erfindungsgemäßer Bauelementhalter für ein auf einer Platine zu montierendes und an einen Kühlkörper anzudrückendes elektronisches Bauelement umfasst eine Aufnahme für das Bauelement und einen Rastfederarm, durch den der Bauelementhalter mittels einer Rastverbindung bezüglich des Kühlkörpers fixierbar und gleichzeitig ein gehaltenes Bauelement an den Kühlkörper andrückbar ist.

Ein in der Aufnahme aufgenommenes Bauelement, z.B. ein IC, wird allein durch den Bauelementhalter gehalten, ohne dass zusätzliche Bauteile, wie beispielsweise ein Kühlkörper oder ein Chassis, zur Halterung erforderlich sind. Das Bauelement kann deshalb auf einfache Weise und insbesondere unabhängig von einer Unterstützung durch andere Bauteile auf einer Platine, z.B. einem Audio-Board, montiert werden. Dies erweist sich als besonders vorteilhaft, wenn das Bauelement hochkant, d.h. rechtwinklig zur Platine, auf der Platine angeordnet wird.

Der Rastfederarm erfüllt erfindungsgemäß eine Doppelfunktion: zum einen sorgt er für eine Fixierung des Bauelementhalters bezüglich des Kühlkörpers, beispielsweise indem er an einem entsprechend ausgebildeten Rastelement des Kühlkörpers oder eines Chassis einrastet. Dadurch wird eine zusätzliche Stabilisierung des Bauelementhalters und somit des Bauelements auf der Platine erreicht. Zum anderen drückt der Rastfederarm das Bauelement zur Schaffung eines thermischen Kontakts zwischen Bauelement und Kühlkörper an den Kühlkörper an. Zwischen dem Bauelement und dem Kühlkörper kann eine Wärmeleitfolie angeordnet sein, deren Dicke sich mit variierender Temperatur verändern kann. Aufgrund der Federeigenschaften des Rastfederarms werden derartige Schwankungen der Dicke der Wärmeleitfolie ausgeglichen, so dass stets eine optimale thermische Anbindung des Bauelements an den Kühlkörper gewährleistet ist.

Gemäß einer vorteilhaften Ausführungsform des Bauelementhalters weist der Rastfederarm eine in Richtung des zu haltenden Bauelements weisende Wölbung auf, die im verrasteten Zustand des Rastfederarms auf einen zentralen Bereich des zu haltenden Bauelements Druck ausübt. Durch die Wölbung ist die Elastizität des Rastfederarms erhöht und die durch den Rastfederarm maximal auf das Bauelement ausgeübte Kraft begrenzt. Die Wölbung trägt folglich dazu bei, dass das Bauelement beim Andrücken an den Kühlkörper nicht beschädigt wird. Das Einwirken der Wölbung auf einen zentralen Bereich des Bauelements führt außerdem zu einer optimalen Verteilung der Kraft, mit welcher der Rastfederarm auf das Bauelement drückt.

Bevorzugt weist die Aufnahme Fixiermittel zur Fixierung des Bauelements in der Aufnahme auf. Die Fixiermittel sorgen dafür, dass das Bauelement sicher in der Aufnahme des Bauelementhalters gehalten ist. Die Fixiermittel können wenigstens eine Klemmlasche zur seitlichen Klemmung des gehaltenen Bauelements, wenigstens einen Anschlag für eine von der Platine weg weisende Oberseite des gehaltenen Bauelements und/oder wenigstens einen Vorsprung umfassen, der in eine entsprechende Aussparung eines gehaltenen Bauelements eingreift, um ein Herausrutschen des Bauelements aus der Aufnahme zu verhindern.

Besonders vorteilhaft ist es, wenn ein Sicherungsmittel vorgesehen ist, um den Bauelementhalter zusätzlich in einem zu der Rastverbindung beabstandeten Bereich bezüglich des Kühlkörpers zu fixieren. Zusammen mit der Rastverbindung wird durch das Sicherungsmittel eine Mehrpunktsicherung des Bauelementhalters erreicht, durch die eine noch sicherere Fixierung des Bauelementhalters bezüglich des Kühlkörpers gewährleistet ist.

Das Sicherungsmittel kann hakenartige Fortsetzungen von Seitenwänden der Aufnahme umfassen, die insbesondere so ausgebildet sind, dass sie eine der Platine zugewandte Unterseite des Kühlkörpers hintergreifen können. Die hakenartigen Fortsetzungen bilden zusammen mit der Rastverbindung eine Dreipunktfixierung des Bauelementhalters bezüglich des Kühlkörpers, wodurch eine besonders hohe Stabilität des Ensembles von Bauelement, Bauelementhalter, Platine und Kühlkörper gewährleistet ist.

Der Bauelementhalter ist bevorzugt ein Stanzbiegeteil und lässt sich dadurch mit geringem wirtschaftlichen Aufwand herstellen lässt.

Vorteilhafterweise ist der Bauelementhalter aus Federbronze gebildet, da dieses Material sich - im Gegensatz zu beispielsweise Federstahl - löten lässt. Folglich ist eine Verlötung des Bauelementhalters mit der Platine möglich, wodurch die Befestigung des Bauelementhalters an der Platine besonders sicher wird.

Bei dem erfindungsgemäßen Verfahren wird ein elektronisches Bauelement in einen Bauelementhalter der voranstehend genannten Art eingesetzt, der Bauelementhalter zusammen mit dem Bauelement auf die Platine aufgesetzt, die Platine anschließend mit einem einen Kühlkörper aufweisenden Chassis verbunden und der Bauelementhalter mittels einer Rastverbindung mit dem Chassis und/oder dem Kühlkörper verbunden, wodurch das Bauelement gleichzeitig an den Kühlkörper angedrückt wird. Insbesondere bei einer hochkantigen Montage des Bauelements auf der Platine kann das in den Bauelementhalter eingesetzte Bauelement sicher und insbesondere ohne zusätzliche Unterstützungsmittel, wie beispielsweise ein Kühlkörper oder ein Chassis, auf der Platine befestigt werden. Eine derart mit Bauelementhalter und Bauelement bestückte Platine ist leicht handhabbar und transportierbar, da die Platine in diesem Stadium ohne Kühlkörper und Chassis sowohl einen geringen Platzbedarf als auch ein geringes Gewicht aufweist. Die Platine kann also kostengünstig an einem Ort mit dem Bauelement bestückt und an einem anderen Ort mit dem Kühlkörper versehen und an dem Chassis befestigt werden.

Weiterer Gegenstand der Erfindung ist außerdem eine Platine, die mit einem einen Kühlkörper aufweisenden Chassis verbunden ist und ein elektrisch mit der Platine verbundenes elektronisches Bauelement aufweist, das in einem an der Platine befestigten Bauelementhalter der voranstehend genannten Art gehalten ist, der mittels einer Rastverbindung mit dem Chassis und/oder dem Kühlkörper verbunden ist und dabei eine Oberfläche des Bauelements an eine Oberfläche des Kühlkörpers andrückt.

Nachfolgend wird die Erfindung rein beispielhaft anhand einer vorteilhaften Ausführungsform unter Bezugnahme auf die beigefügte Zeichnung beschrieben. Es zeigen:
- Fig. 1A und B: perspektivische Ansichten eines erfindungsgemäßen Bauelementhalters;
- Fig. 2: einen Querschnitt des Bauelementhalters von Fig. 1;
- Fig. 3: eine perspektivische Ansicht des Bauelementhalters von Fig. 1 mit gehaltenem Bauelement; und
- Fig. 4: eine perspektivische Ansicht einer erfindungsgemäßen Platine.

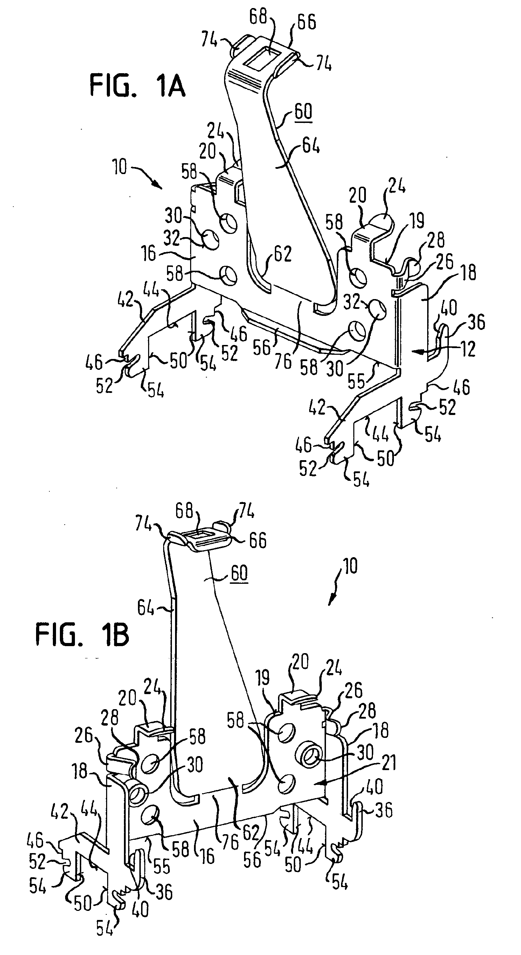

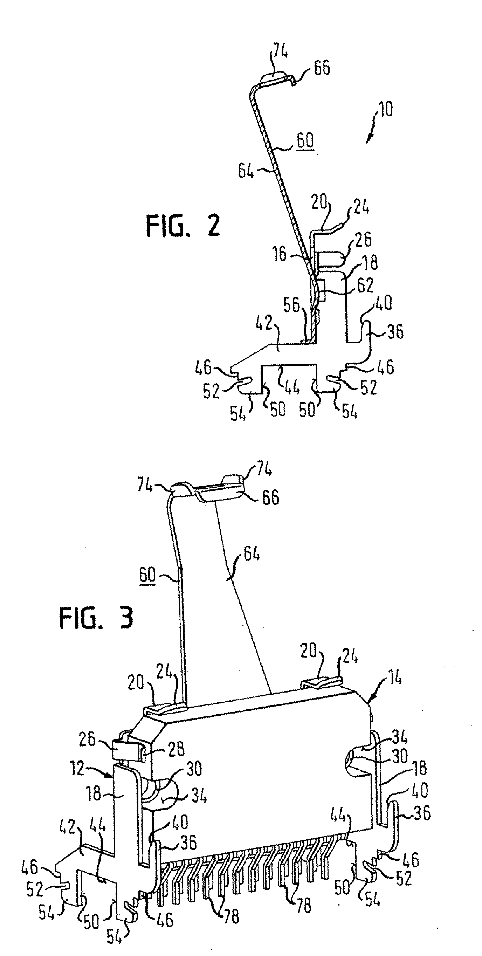

Der in Fig. 1A, B und Fig. 2 dargestellte Bauelementhalter 10 ist ein einstückig ausgebildetes Stanzbiegeteil aus Federbronze und weist eine Aufnahme 12 zur Halterung eines elektronischen Bauelements 14 (Fig. 3), beispielsweise eines Endstufen-ICs, auf. Die Aufnahme 12 umfasst eine Rückwand 16, an gegenüberliegenden Seiten der Rückwand 16 an diese angrenzende Seitenwände 18 und an einem oberen Rand 19 der Rückwand 16 angeordnete Anschlagslaschen 20, die zusammen einen Aufnahmeraum 21 begrenzen.

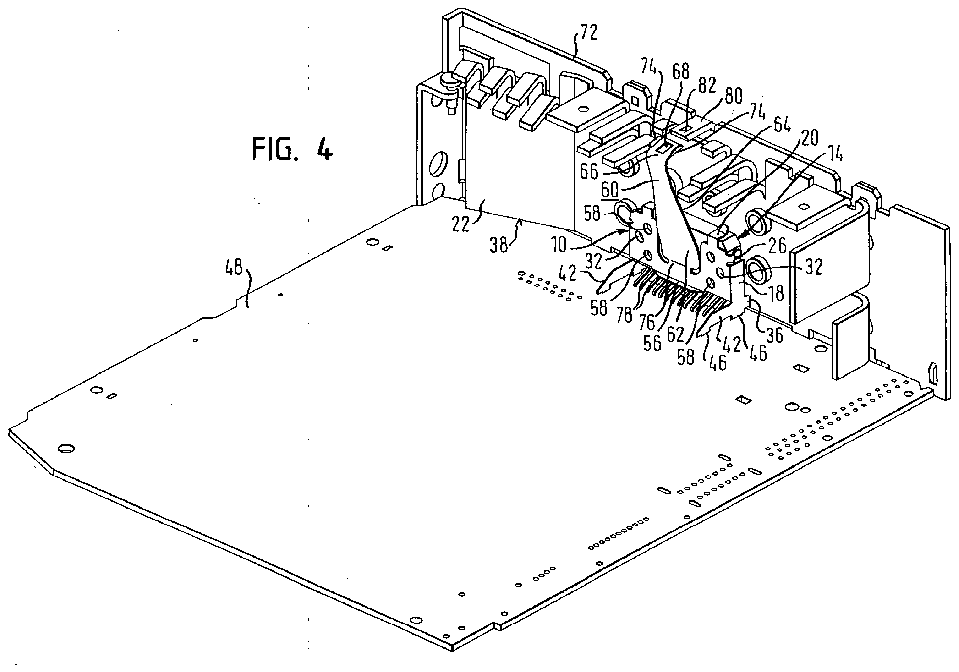

Sowohl die Seitenwände 18 als auch die Anschlagslaschen 20 sind Fortsetzungen der Rückwand 16, die im Wesentlichen rechtwinklig in einer Richtung umgebogen sind, die zu einem Kühlkörper 22 (Fig. 4) weist, an den das Bauelement 14 angedrückt werden soll. Diese Richtung wird im Folgenden als "nach vorne" bezeichnet. Um das Einsetzen des Bauelements 14 in den Aufnahmeraum 21 zu erleichtern, sind die Anschlagslaschen 20 in ihren jeweiligen Endbereichen 24 vom Aufnahmeraum 21 weg (in der Figur nach oben) umgebogen.

Oberhalb jeder Seitenwand 18 ist eine seitliche Klemmlasche 26 angeordnet, die zur Sicherung eines in den Aufnahmeraum 21 eingesetzten Bauelements 14 dient. Wie die Anschlagslaschen 20 sind auch die Klemmlaschen 26 durch nach vorne umgebogene Fortsetzungen der Rückwand 16 gebildet. Im Gegensatz zu den Anschlagslaschen 20 sind die Klemmlaschen 26 jedoch um mehr als 90° umgebogen, und zwar so weit, dass die Klemmlaschen 26 durch ein in die Aufnahme 12 eingesetztes Bauelement 14 auseinander gedrückt werden. Durch die Klemmkraft, welche die Klemmlaschen 26 auf das Bauelement 14 ausüben, ist das Bauelement 14 sicher in dem Bauelementhalter 10 gehalten (Fig. 3). Um das Einsetzen des Bauelements 14 in Aufnahme 12 zu erleichtern, sind auch die Endbereiche 28 der Klemmlaschen 26 vom Aufnahmeraum 21 weg, d.h. nach außen, umgebogen.

Im Bereich jeder Seitenwand 18 weist die Rückwand 16 jeweils einen Vorsprung 30 auf. Die Vorsprünge 30 sind durch hohlzylindrische Ausstülpungen der Rückwand 16 gebildet, die z.B. beim Einstanzen von Öffnungen 32 in die Rückwand 16 entstehen. Wie in Fig. 3 zu erkennen ist, sind die Vorsprünge 30 derart positioniert, dass sie in entsprechende seitliche Aussparungen 34 eines in den Aufnahmeraum 21 eingesetzten Bauelements 14 eingreifen. Auf diese Weise sichern die Vorsprünge 30 das Bauelement 14 gegen ein Herausrutschen aus dem Aufnahmeraum 21 und gewährleisten so zusammen mit den Klemmlaschen 26 einen sicheren Sitz des Bauelements 14 in dem Bauelementhalter 10.

Die Fig. 1A, B und 2 zeigen ferner, dass in einem vorderen unteren Bereich jeder Seitenwand 18 Sicherungshaken 36 vorgesehen sind, die jeweils durch eine sich zunächst nach vorne und dann nach oben erstreckende Fortsetzung der Seitenwand 18 gebildet ist. Die Sicherungshaken 36 dienen zum Hintergreifen einer Unterseite 38 eines für die Kühlung des Bauelements 14 vorgesehen Kühlkörpers 22 (Fig. 4). Um das Einführen der Kühlkörperunterseite 38 in die Sicherungshaken 36 zu erleichtern, sind die Sicherungshaken 36 in ihren jeweiligen Endbereichen 40 abgeschrägt.

An der Rückseite der Aufnahme 12 geht unterhalb der Rückwand 16 ein sich nach hinten erstreckender Trägerabschnitt 42 aus jeder Seitenwand 18 hervor. An einer Unterseite 44 jedes Trägerabschnitts 42 sind jeweils zwei Schulterabschnitte 46 ausgebildet, die im Endmontagezustand auf einer Platine 48 aufsitzen (Fig. 4). An jeden Schulterabschnitt 46 schließt sich nach unten ein Ankerabschnitt 50 an, der zur Verankerung des Bauelementhalters 10 an der Platine 48 vorgesehen ist. Die Ankerabschnitte 50 sind jeweils so ausgebildet, dass sie jeweils durch eine in der Platine 48 entsprechend vorgesehene Öffnung hindurchragen und die Platine 48 hintergreifen können. Im dargestellten Ausführungsbeispiel ist jeder Ankerabschnitt 50 mit einem Schlitz 52 versehen, der das Umbiegen oder Verschränken eines Endbereichs 54 des Ankerabschnitts 50 auf der Platinenrückseite erleichtert. Alternativ ist es aber auch möglich, die Ankerabschnitte 50 in ihren Endbereichen 54 mit einer Rastwölbung oder mit einem Rasthaken zu versehen, die bzw. der beim Aufsetzen des Bauelementhalters 10 auf die Platine 48 eine Rastverbindung, insbesondere eine Schnapprastverbindung, zwischen dem Bauelementhalter 10 und der Platine 48 schafft.

An der Unterseite 55 der Rückwand 16 ist ein Fortsatz 56 der Rückwand 16 nach hinten umgebogen. Der Fortsatz 56 wirkt als Versteifungselement für den Bauelementhalter 10. Ferner sind mehrere kreisförmige Öffnungen 58 in der Rückwand 16 vorgesehen, um das Gewicht des Bauelementhalters 10 zu reduzieren.

Oberhalb des Versteifungselements 56 geht ein Rastfederarm 60 aus der Rückwand 16 hervor. Ausgehend von der Rückwand 16 umfasst der Rastfederarm 60 einen Wölbungsabschnitt 62, einen Zwischenabschnitt 64 und einen Rastabschnitt 66.

Der Rastabschnitt 66 bildet mit dem Zwischenabschnitt 64 etwa einen rechten Winkel und weist eine Rastöffnung 68 auf. Die Rastöffnung 68 ist so ausgebildet, dass sie einen Rastvorsprung 82 eines Chassis 72 aufnehmen kann, um den Bauelementhalter 10 und ein in den Bauelementhalter 10 eingesetztes Bauelement 14 im Endmontagezustand am Chassis zu fixieren. Der Rastabschnitt 66 weist ferner nach oben gebogene seitliche Flügel 74 auf, die den Rastabschnitt 66 versteifen, als Führung für einen den Rastvorsprung 82 tragenden Halteabschnitt 80 des Chassis 72 (Fig. 4) dienen und die Handhabung des Rastfederarms 60 erleichtern.

Der Zwischenabschnitt 46 verbreitert sich ausgehend vom Rastabschnitt 66 in Richtung des Wölbungsabschnitts 62. Im Bereich des Wölbungsabschnitts 62 weist der Rastfederarm 60 seine maximale Breite auf. Im Bereich des Wölbungsabschnitts 62 ist der Rastfederarm 60 ferner nach vorne, d.h. in den Aufnahmeraum 21 hinein gewölbt. Der Bereich, in dem der Wölbungsabschnitt 62 am weitesten in den Aufnahmeraum 21 hineinragt, ist so angeordnet, dass der Rastfederarm 60 über seinen Wölbungsabschnitt 62 in einem zentralen Bereich der Rückseite eines in die Aufnahme 12 eingesetzten Bauelements 14 mit diesem in Kontakt steht.

Durch einen Verbindungssteg 76 ist der Rastfederarm 60 mit der Rückwand 16 verbunden. Der Verbindungssteg 76 weist etwa eine Breite auf, die der Breite des Rastabschnitts 66 des Rastfederarms 60 entspricht.

Fig. 3 zeigt einen Bauelementhalter 10, in dessen Aufnahme 12 ein Bauelement 14 eingesetzt ist. Das Bauelement 14 weist eine Vielzahl von elektrischen Anschlusselementen 78 auf, die zur elektrischen Verbindung des Bauelements 14 mit auf der Platine 48 vorgesehenen Leiterbahnen dienen.

Der Zusammenbau von Platine 48, Bauelementhalter 10, Bauelement 14, Kühlkörper 22 und Chassis 72 erfolgt erfindungsgemäß folgendermaßen:

Zunächst wird das Bauelement 14 in den Bauelementhalter 10 eingesetzt, wie es in Fig. 3 dargestellt ist. Der Bauelementhalter 10 wird dann zusammen mit dem Bauelement 14 derart auf eine Oberseite der Platine 48 aufgesetzt, dass die Ankerabschnitte 50 des Bauelementhalters 10 durch entsprechende Öffnungen der Platine 48 eingreifen. Die Öffnungen bewirken eine einfache und genaue Platzierung des Bauelementhalters 10 auf der Platine 48. Zur Sicherung des Bauelementhalters 10 an der Platine 48 werden die Endbereiche 54 der Ankerabschnitte 50, welche durch die Öffnungen der Platine 48 hindurchragen, auf der Platinenrückseite umgebogen. Alternativ können entsprechend ausgebildete Ankerabschnitte 50 in den Platinenöffnungen einschnappen oder einrasten.

Die genaue Platzierung des Bauelementhalters 10 gewährleistet gleichzeitig eine exakte Positionierung des Bauelements 14 bezüglich der Platine 48, so dass die elektrischen Anschlusselemente 78 des Bauelements 14 relativ zu ihren jeweils zu kontaktierenden Leiterbahnen der Platine 48 korrekt angeordnet sind. In einem sich anschließenden Verfahrensschritt wird durch ein geeignetes Lötverfahren eine Lötverbindung zwischen den Anschlusselementen 78 und den entsprechenden Leiterbahnen der Platine 48 geschaffen. In demselben Verfahrensschritt werden die Ankerabschnitte 50 mit der Platine 48 verlötet. Die Verlötung von Anschlusselementen 78 und Leiterbahnen einerseits und von Ankerabschnitten 50 und Platine 48 andererseits erfolgt also gleichzeitig. Damit eine Lötverbindung zwischen dem Bauelementhalter 10 und der Platine 48 geschaffen werden kann, ist der Bauelementhalter 10 aus Federbronze gebildet.

Durch den so an der Platine 48 befestigten Bauelementhalter 10 ist das Bauelement 14 sicher auf der Platine 48 gehalten. Insbesondere ist das Bauelement 14 durch den Bauelementhalter 10 vor einer Verschiebung oder Verkippung bezüglich der Platine 48 geschützt, durch welche die Lötverbindung der elektrischen Anschlusselemente 78 des Bauelements 14 mit den Leiterbahnen der Platine 48 oder das Bauelement 14 selbst beschädigt werden könnte. Dies gilt vor allem dann, wenn das Bauelement 14 - wie es in Fig. 3 und 4 dargestellt ist - hochkant auf der Platine 48 montiert wird. Die auf diese Weise mit dem Bauelementhalter 10 und dem Bauelement 14 bestückte Platine 48 ist leicht zu handhaben und kostengünstig zu transportieren.

In einem nächsten Verfahrensschritt wird die bestückte Platine 48 mit einem Chassis 72 verschraubt. Das Chassis 72 ist dabei rechtwinklig zur Platine 48 orientiert und mit einem Kühlkörper 22 versehen, der an der zur Platine 48 weisenden Seite des Chassis 72 mit dem Chassis 72 verbunden, beispielsweise vernietet, getoxt oder verschraubt, ist. Die Platine 48 wird derart an das Chassis 72 angesetzt, dass die Sicherungshaken 36 des Bauelementhalters 10 den Kühlkörper 22 an seiner Unterseite unter-und hintergreifen.

An der Oberseite des Chassis 72 ist ein in Richtung der Platine 48 weisender und etwa rechtwinklig zum Chassis 72 orientierter Halteabschnitt 80 vorgesehen, der an seiner zur Platine weisenden Unterseite einen Rasthaken 82 aufweist. Der Halteabschnitt 80 ist derart positioniert, dass der Rasthaken 82 von oben in die Rastöffnung 68 des Rastfederarms 60 einrasten kann, wenn der Rastfederarm 60 zur Verriegelung des Bauelementhalters 10 an dem Chassis 72 in Richtung des Chassis 72 gedrückt wird. Die am Rastabschnitt 66 des Rastfederarms 60 vorgesehenen Flügel 74 wirken dabei als Führung für den Halteabschnitt 80 und erleichtern das Einrasten des Rastfederarms 60 am Chassis 72.

Im dargestellten Ausführungsbeispiel ist die Rastöffnung 68 im Rastfederarm 60 und der Rasthaken 82 am Chassis 72 vorgesehen. Alternativ ist auch eine umgekehrte Ausführungsform möglich, bei welcher der Rasthaken am Chassis 72 und die Rastöffnung entsprechend im Rastfederarm 60 ausgebildet ist. Anstatt das entsprechende Rastelement am Chassis vorzusehen, ist es außerdem möglich, dieses am Kühlkörper 22 auszubilden.

Fig. 4 zeigt die am Chassis 72 befestigte Platine 48 im nicht verrasteten Zustand des Bauelementhalters 10. Ist der Rastfederarm 60 am Rasthaken 82 des Chassis 72 eingerastet, so ist der Bauelementhalter 10 an drei Punkten mit dem Chassis 72 verbunden, nämlich zum einen über die Rastverbindung zwischen Federarm 60 und Halteabschnitt 80 und zum anderen durch die den mit dem Chassis 72 fest verbundenen Kühlkörper 22 hintergreifenden Sicherungshaken 36. Aufgrund dieser Dreipunktbefestigung des Bauelementhalters 10 am Chassis 72 ist das Bauelement 14 sicher bezüglich des Kühlkörpers 22 fixiert.

Durch den Wölbungsabschnitt 62 des verriegelten Rastfederarms 60 wird das Bauelement 14 gegen den Kühlkörper 22 gedrückt, um eine thermische Anbindung des Bauelements 14 an den Kühlkörper 22 zu schaffen. Zur Verbesserung des thermischen Kontaktes zwischen Bauelement 14 und Kühlkörper 22 kann eine Wärmeleitfolie zwischen dem Bauelement 14 und dem Kühlkörper 22 angeordnet sein. Temperaturbedingte Schwankungen der Dicke der Wärmeleitfolie werden durch die Federeigenschaften des Rastfederarms 60 ausgeglichen. Auf diese Weise ist ein optimaler thermischer Kontakt zwischen dem Bauelement 14 und dem Kühlkörper 22 dauerhaft gewährleistet.

Der erfindungsgemäße Bauelementhalter erfüllt seine Funktionen, insbesondere die Halterung eines Bauelements und das Andrücken des Bauelements an einen Kühlkörper, besonders gut für alle IC's stehender Bauart.

### Bezugszeichenliste

- 10: Bauelementhalter
- 12: Aufnahme
- 14: Bauelement
- 16: Rückwand
- 18: Seitenwand
- 19: oberer Rand
- 20: Anschlagslasche
- 21: Aufnahmeraum
- 22: Kühlkörper
- 24: Endbereich
- 26: Klemmlasche
- 28: Endbereich
- 30: Vorsprung
- 32: Öffnung
- 34: Aussparung
- 36: Sicherungshaken
- 38: Unterseite
- 40: Endbereich
- 42: Trägerabschnitt
- 44: Unterseite
- 46: Sockelabschnitt
- 48: Platine
- 50: Ankerabschnitt
- 52: Schlitz
- 54: Endbereich
- 55: Unterseite
- 56: Versteifungselement
- 58: Öffnung
- 60: Rastfederarm
- 62: Wölbungsabschnitt
- 64: Zwischenabschnitt
- 66: Rastabschnitt
- 68: Rastöffnung
- 72: Chassis
- 74: Flügel
- 76: Verbindungssteg
- 78: Anschlusselement
- 80: Halteabschnitt
- 82: Rasthaken

## Patentansprüche

1. Bauelementhalter (10) für ein auf einer Platine (48) zu montierendes und an einen Kühlkörper (22) anzudrückendes elektronisches Bauelement (14) mit einer Aufnahme (12) für das Bauelement (14) und mit einem Rastfederarm (60) durch den der Bauelementhalter (10) mittels einer Rastverbindung bezüglich des Kühlkörpers (22) fixierbar und gleichzeitig ein gehaltenes Bauelement (14) an den Kühlkörper (22) andrückbar ist.

2. Bauelementhalter (10) nach Anspruch 1,
**dadurch gekennzeichnet, dass**
der Rastfederarm (60) aus einer Rückwand (16) der Aufnahme (12) hervorgeht, an der eine dem Kühlkörper (22) abgewandte Oberfläche eines gehaltenen Bauelements (14) anliegt.

3. Bauelementhalter (10) nach Anspruch 2,
**dadurch gekennzeichnet, dass**
der Rastfederarm (60) eine in Richtung des zu haltenden Bauelements (14) weisende Wölbung (62) aufweist, die im verrasteten Zustand des Rastfederarms (60) auf einen zentralen Bereich des zu haltenden Bauelements (14) Druck ausübt.

4. Bauelementhalter (10) nach einem der vorherigen Ansprüche,
**dadurch gekennzeichnet, dass**
die Aufnahme (12) Fixiermittel (20, 26, 30) zur Fixierung des Bauelements (14) in einem Aufnahmeraum (21) der Aufnahme (12) aufweist.

5. Bauelementhalter (10) nach Anspruch 4,
**dadurch gekennzeichnet, dass**
die Fixiermittel wenigstens eine Klemmlasche (26) zur seitlichen Klemmung des gehaltenen Bauelements (14), wenigstens einen Anschlag (20) für eine von der Platine (48) weg weisende Oberseite des gehaltenen Bauelements (14) und/oder wenigstens einen Vorsprung (30) umfassen, der in eine entsprechende Aussparung (34) eines gehaltenen Bauelements (14) eingreift, um ein Herausrutschen des Bauelements (14) aus der Aufnahme (12) zu verhindern.

6. Bauelementhalter (10) nach einem der vorherigen Ansprüche,
**dadurch gekennzeichnet, dass**
ein Sicherungsmittel (36) vorgesehen ist, um den Bauelementhalter (10) zusätzlich in einem zu der Rastverbindung beabstandeten Bereich bezüglich des Kühlkörpers (22) zu fixieren.

7. Bauelementhalter (10) nach Anspruch 6,
**dadurch gekennzeichnet, dass**
das Sicherungsmittel hakenartige Fortsetzungen (36) von Seitenwänden (18) der Aufnahme (12) umfasst, die insbesondere so ausgebildet sind, dass sie eine der Platine (48) zugewandte Unterseite (38) des Kühlkörpers (22) hintergreifen können.

8. Verfahren zum Montieren eines elektronischen Bauelements (14) auf einer Platine (48), bei dem
das elektronische Bauelement (14) in einen Bauelementhalter (10), insbesondere nach einem der Ansprüche 1 bis 7, eingesetzt wird,
der Bauelementhalter (10) zusammen mit dem Bauelement (14) auf die Platine (48) aufgesetzt wird,
die Platine (48) anschließend mit einem einen Kühlkörper (22) aufweisenden Chassis (72) verbunden wird, und
der Bauelementhalter (10) mittels einer Rastverbindung mit dem Chassis (72) und/oder dem Kühlkörper (22) verbunden wird, wodurch das Bauelement (14) gleichzeitig an den Kühlkörper (22) angedrückt wird.

9. Verfahren nach Anspruch 8,
**dadurch gekennzeichnet, dass**
Ankerabschnitte (50) des Bauelementhalters (10), die beim Aufsetzen des Bauelementhalters (10) auf eine Vorderseite der Platine (48) durch in der Platine (48) entsprechend vorgesehene Öffnungen hindurchgeführt werden, auf der Rückseite der Platine (48) einschnappen, einrasten oder verschränkt werden.

10. Verfahren nach Anspruch 9,
**dadurch gekennzeichnet, dass**
die Ankerabschnitte (50) zusätzlich mit der Platine (48) verlötet werden, vorzugsweise in einem Verfahrensschritt, bei dem auch Anschlusselemente (78) des Bauelements (14) mit Leiterbahnen der Platine (48) verlötet werden.

11. Platine (48), die mit einem einen Kühlkörper (22) aufweisenden Chassis (72) verbunden ist und ein elektrisch mit der Platine (48) verbundenes elektronisches Bauelement (14) aufweist, das in einem an der Platine (48) befestigten Bauelementhalter (10) nach einem der Ansprüche 1 bis 7 gehalten ist, der mittels einer Rastverbindung mit dem Chassis (72) und/oder dem Kühlkörper (22) verbunden ist und dabei eine Oberfläche des Bauelements (14) an eine Oberfläche des Kühlkörpers (22) andrückt.

12. Platine (48) nach Anspruch 11,
**dadurch gekennzeichnet, dass**
die Oberflächen des Kühlkörpers (22) und des Bauelements (14) im Wesentlichen rechtwinklig zur Platine (48) orientiert sind.

13. Platine (48) nach Anspruch 11 oder 12,
**dadurch gekennzeichnet, dass**
die Rastverbindung platinenfern erfolgt und der Bauelementhalter (10) platinennah zusätzlich mit dem Kühlkörper (22) verbunden und insbesondere an diesem eingehakt ist.

14. Platine (48) nach einem der Ansprüche 11 bis 13,
**dadurch gekennzeichnet, dass**
der Bauelementhalter (10) mittels durch die Platine (48) hindurchragender Ankerabschnitte (50) an der Platine (48) befestigt ist, welche die Platine (48) bevorzugt hintergreifen und/oder mit der Platine (48) verlötet sind.

## Geänderte Patentansprüche

### Geänderte Patentansprüche gemäss Regel 86(2) EPÜ.

**1.** Bauelementhalter (10) für ein auf einer Platine (48) zu montierendes und an einen Kühlkörper (22) anzudrückendes elektronisches Bauelement (14) mit einer Aufnahme (12) für das Bauelement (14) und mit einem Rastfederarm (60) durch den der Bauelementhalter (10) mittels einer Rastverbindung bezüglich des Kühlkörpers (22) fixierbar und gleichzeitig ein gehaltenes Bauelement (14) an den Kühlkörper (22) andrückbar ist,
**dadurch gekennzeichnet, dass**
die Aufnahme Fixiermittel (20, 26, 30) zur Fixierung des Bauelements (14) in einem Aufnahmeraum (21) der Aufnahme (12) aufweist, wobei die Fixiermittel wenigstens einen Vorsprung (30) umfassen, der in eine entsprechende Aussparung (34) eines gehaltenen Bauelements (14) eingreift, um ein Herausrutschen des Bauelements (14) aus der Aufnahme (12) zu verhindern, und
Ankerabschnitte (50) zur Verankerung des Bauelementhalters (10) an der Platine (48) vorgesehen sind.

**2.** Bauelementhalter (10) nach Anspruch 1,
**dadurch gekennzeichnet, dass**
der Rastfederarm (60) aus einer Rückwand (16) der Aufnahme (12) hervorgeht, an der eine dem Kühlkörper (22) abgewandte Oberfläche eines gehaltenen Bauelements (14) anliegt.

**3.** Bauelementhalter (10) nach Anspruch 2,
**dadurch gekennzeichnet, dass**
der Rastfederarm (60) eine in Richtung des zu haltenden Bauelements (14) weisende Wölbung (62) aufweist, die im verrasteten Zustand des Rastfederarms (60) auf einen zentralen Bereich des zu haltenden Bauelements (14) Druck ausübt.

**4.** Bauelementhalter (10) nach einem der vorherigen Ansprüche,
**dadurch gekennzeichnet, dass**
die Fixiermittel wenigstens eine Klemmlasche (26) zur seitlichen Klemmung des gehaltenen Bauelements (14) und/oder wenigstens einen Anschlag (20) für eine von der Platine (48) weg weisende Oberseite des gehaltenen Bauelements (14) umfassen.

**5.** Bauelementhalter (10) nach einem der vorherigen Ansprüche,
**dadurch gekennzeichnet, dass**
ein Sicherungsmittel (36) vorgesehen ist, um den Bauelementhalter (10) zusätzlich in einem zu der Rastverbindung beabstandeten Bereich bezüglich des Kühlkörpers (22) zu fixieren.

**6.** Bauelementhalter (10) nach Anspruch 5,
**dadurch gekennzeichnet, dass**
das Sicherungsmittel hakenartige Fortsetzungen (36) von Seitenwänden (18) der Aufnahme (12) umfasst, die insbesondere so ausgebildet sind, dass sie eine der Platine (48) zugewandte Unterseite (38) des Kühlkörpers (22) hintergreifen können.

**7.** Verfahren zum Montieren eines elektronischen Bauelements (14) auf einer Platine (48), bei dem
das elektronische Bauelement (14) in einen Bauelementhalter (10) nach einem der Ansprüche 1 bis 6 eingesetzt wird,
der Bauelementhalter (10) zusammen mit dem Bauelement (14) auf die Platine (48) aufgesetzt wird,
die Platine (48) anschließend mit einem einen Kühlkörper (22) aufweisenden Chassis (72) verbunden wird, und
der Bauelementhalter (10) mittels einer Rastverbindung mit dem Chassis (72) und/oder dem Kühlkörper (22) verbunden wird, wodurch das Bauelement (14) gleichzeitig an den Kühlkörper (22) angedrückt wird.

**8.** Verfahren nach Anspruch 7,
**dadurch gekennzeichnet, dass**
die Ankerabschnitte (50) beim Aufsetzen des Bauelementhalters (10) auf eine Vorderseite der Platine (48) durch in der Platine (48) entsprechend vorgesehene Öffnungen hindurchgeführt werden und auf der Rückseite der Platine (48) einschnappen, einrasten oder verschränkt werden.

**9.** Verfahren nach Anspruch 8,
**dadurch gekennzeichnet, dass**
die Ankerabschnitte (50) zusätzlich mit der Platine (48) verlötet werden, vorzugsweise in einem Verfahrensschritt, bei dem auch Anschlusselemente (78) des Bauelements (14) mit Leiterbahnen der Platine (48) verlötet werden.

**10.** Platine (48), die mit einem einen Kühlkörper (22) aufweisenden Chassis (72) verbunden ist und ein elektrisch mit der Platine (48) verbundenes elektronisches Bauelement (14) aufweist, das in einem an der Platine (48) befestigten Bauelementhalter (10) nach einem der Ansprüche 1 bis 6 gehalten ist, der mittels einer Rastverbindung mit dem Chassis (72) und/oder dem Kühlkörper (22) verbunden ist und dabei eine Oberfläche des Bauelements (14) an eine Oberfläche des Kühlkörpers (22) andrückt.

**11.** Platine (48) nach Anspruch 10,
**dadurch gekennzeichnet, dass**
die Oberflächen des Kühlkörpers (22) und des Bauelements (14) im Wesentlichen rechtwinklig zur Platine (48) orientiert sind.

**12.** Platine (48) nach Anspruch 10 oder 11,
**dadurch gekennzeichnet, dass**
die Rastverbindung platinenfern erfolgt und der Bauelementhalter (10) platinennah zusätzlich mit dem Kühlkörper (22) verbunden und insbesondere an diesem eingehakt ist.

**13.** Platine (48) nach einem der Ansprüche 10 bis 12,
**dadurch gekennzeichnet, dass**
der Bauelementhalter (10) mittels durch die Platine (48) hindurchragender Ankerabschnitte (50) an der Platine (48) befestigt ist, welche die Platine (48) bevorzugt hintergreifen und/oder mit der Platine (48) verlötet sind.
